(19) **Europäisches Patentamt / European Patent Office / Office européen des brevets**

(11) **EP 2 654 148 B1**

(12) **EUROPEAN PATENT SPECIFICATION**

(45) Date of publication and mention of the grant of the patent:
**07.08.2019 Bulletin 2019/32**

(21) Application number: **11848150.6**

(22) Date of filing: **13.12.2011**

(51) Int Cl.:
*H02B 1/30* (2006.01)     *G01J 1/02* (2006.01)
*G01J 5/48* (2006.01)     *G01N 25/72* (2006.01)
*H02B 1/40* (2006.01)

(86) International application number:
**PCT/JP2011/078817**

(87) International publication number:
**WO 2012/081586 (21.06.2012 Gazette 2012/25)**

(54) **INFRARED TRANSMISSIVE PROTECTIVE COVER, MANUFACTURING METHOD FOR SAME, AND MONITORING METHOD USING SAME**

INFRAROTDURCHLÄSSIGE SCHUTZABDECKUNG, HERSTELLUNGSVERFAHREN DAFÜR UND ÜBERWACHUNGSVERFAHREN DAMIT

COUVERCLE PROTECTEUR TRANSMETTANT LES INFRAROUGES, PROCÉDÉ DE FABRICATION CORRESPONDANT ET PROCÉDÉ DE SURVEILLANCE L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2010 JP 2010277410**

(43) Date of publication of application:
**23.10.2013 Bulletin 2013/43**

(73) Proprietors:
- **The Japan Atomic Power Company**
  **Tokyo 101-0053 (JP)**
- **Asahi Kasei Kabushiki Kaisha**
  **Tokyo 100-0006 (JP)**
- **Asahi Kasei Engineering Corporation**
  **Kawasaki-ku, Kawasaki**
  **Kanagawa 210-0024 (JP)**
- **Thermographers Co., Ltd.**
  **Kawasaki-shi, Kanagawa 214-0001 (JP)**

(72) Inventors:
- **NISHIKAWA, Tsuyoshi**
  **Tokyo 101-0053 (JP)**
- **NAKAMURA, Shigeo**
  **Tokyo 101-0053 (JP)**
- **YONEZAWA, Kazuhiro**
  **Tokyo 101-0053 (JP)**
- **TAKEYAMA, Hidenobu**
  **Tokyo 101-8101 (JP)**
- **HIGASA, Hisakazu**
  **Tokyo 101-8101 (JP)**
- **HIRASHIMA, Akihiro**
  **Tokyo 101-8101 (JP)**
- **MATSUNAGA, Tetsushi**
  **Kawasaki-shi, Kanagawa 214-0001 (JP)**

(74) Representative: **D Young & Co LLP**
**120 Holborn**
**London EC1N 2DY (GB)**

(56) References cited:
JP-A- 3 006 427     JP-A- 7 035 620
JP-A- 11 084 233     JP-A- 11 295 501
JP-A- 52 120 348     JP-A- 63 187 130
JP-A- 2002 234 774

**Description**

Technical Field

The present invention relates to an infrared transmissive protective cover, a method for manufacturing the same, and a monitoring method using the same.

Background Art

For using electricity, such a method is employed in which distribution boards and the like are used to transmit electricity to electric apparatuses and electrical installations that need electricity. To prevent electric accidents, it is necessary to secure safety of the distribution boards in the first place. For example, in order to secure the safety of operators, a distribution board is equipped with an insulating protective cover and the like. However, if the insulating protective cover is opaque to visible rays, conditions such as a connection state inside the protective cover cannot visually be checked from the outside of the protective cover. In that case, the protective cover needs to be removed from the distribution board to check the conditions such as the connection state. As a result, the distribution board is exposed without the protection of the protective cover, which makes it impossible to secure the safety of the operators. From such a viewpoint, insulating materials which transmit visible rays, such as glass, acrylic resin, and polycarbonate are used for the protective cover.

With respect to the protective covers placed for the electrical installations, Patent Document 1 discloses a protective cover for an instrument that is built into a switchboard. In Patent Document 1, it is proposed to provide a protective cover, for protecting an instrument that is built into a switchboard (built-in instruments), on a front surface side of the instrument. An insulating plastic sheet having transparency is proposed as a material of the protective cover to be used.

In Patent Document 2, a protective cover for an electrical apparatus is proposed in which a line of operation parts placed in the electrical apparatus are protected with use of an insulating slide fastener and only an operation part that is desired to be operated is exposed by opening the slide fastener where necessary. In such a protective cover, it becomes possible to open only a part of the fastener that covers a terminal portion which should be operated, and therefore, the state of the terminal portion can visually be checked without removing the protective cover, so that workability may be enhanced to some extent. However, in the state of the faster being opened, the terminal portion is exposed, which causes safety issues.

As for maintenance inspection methods for important facilities such as nuclear power plants, a monitoring method for monitoring installations inside a distribution board with use of an infrared sensor is being examined in recent years for the cases where security inspection for the installations inside the distribution board has conventionally been carried out only by visual tests. Since electricity needs to be turned off in visual tests, operation of electric apparatuses and electric installations which are placed downstream from the distribution board needs to be stopped. This causes a problem of a large economic loss. In order to solve such a problem, a method is desired capable of implementing maintenance inspection and monitoring while electricity is being supplied. From this viewpoint, a monitoring method with use of an infrared sensor in particular may be a simple and economical method since it does not need to stop operation of electric apparatuses and electric installations.

JP-A-03 006427 discloses a temperature detector which is covered by a window which is capable of transmitting heat radiation. The radiant heat-permeable window material is a translucent or transparent polyethylene sheet having a thickness of 10 to 50 μm.

JP-A-11 084233 discloses a lens which is capable of transmitting infra red rays and made from olefinic resin.

Patent Document

Patent Document 1: Japanese Patent Laid-Open No. 07-143621
Patent Document 2: Japanese Patent Laid-Open No. 2008-029119
Patent Document 3: Japanese Patent Laid-Open No. 05-043268
Patent Document 4: Japanese Patent Laid-Open No. 2001-200108

Summary of the Invention

Problems to be Solved by the Invention

Under such circumstances, a method has been desired which can perform monitoring easily, efficiently and remotely while securing the safety of operators without stopping supplying electricity and without the trouble of removing the protective cover.

However, there are problems to be solved regarding the material of the above-mentioned conventional protective covers. For example, since the above-mentioned protective covers made of such materials as glass, acrylic boards, and polycarbonate boards have high optical absorptance in an infrared region that infrared sensors use, it is difficult to conduct a test with infrared rays. Thus, with the conventional protective covers, it is difficult to conduct both the inspection by visual observation and the inspection using an infrared sensor in the state of the protective covers being mounted.

In Patent Document 3, filters and lens materials which have a property of transmitting visible rays and infrared rays are disclosed. Materials such as KRS-5 (a mixture of thallium bromide and thallium iodide), which also have a property of transmitting infrared rays, are widely used as the material of filters and lenses or the like. However, in the technology of Patent Document 3 a used material is an extremely special glass basically composed of germanium, sulfur and halogen. One of these basic components, germanium is a very expensive material, so that it is not practical to adopt the material for broad and industrial use. Moreover, germanium tends to be easily oxidized with steam, which poses a problem of deteriorated transparency to infrared rays.

Moreover, although KRS-5 has a property of transmitting a wide range of light from visible light to infrared light, toxicity of thallium has extremely high toxicity, which causes serious safety issues. Examples of other materials that transmit infrared rays include infrared crystals such as zinc selenide (ZnSe) and gallium arsenide (GaAs). However, these materials are all very expensive, and it is therefore not practical, from an economic point of view, to use them as the material of the protective covers for distribution boards.

Patent Document 4 discloses a molded article formed by blending a white additive with polyethylene resin. However, the molded article disclosed in Patent Document 4 has disadvantages that the white additive needs to be added and that the transparency to visible rays is poor. Accordingly, it is difficult to conduct both the inspection by visual observation and the inspection using an infrared sensor even when the molded article disclosed in Patent Document 4 is used as a protective cover. Thus, under present circumstances, there is no material, according to the conventional technology, which can be considered to be practical in terms of transparency to both visible rays and infrared rays, economic efficiency, safety, and other performances.

The present invention has been made in view of the above-stated circumstances and it is an object of the present invention to provide a practical infrared transmissive protective cover capable of detecting abnormalities such as a heating abnormality of an internal heating element by visual observation and with infrared rays.

Means for Solving the Problems

In view of the above, as a result of intensive studies on the above-mentioned problems, the inventors of the present invention have found out that using an infrared transmissive protective cover that is made of a resin sheet containing a resin composition and which has a light transmission section having a specific transmittance to visible rays and infrared rays can accomplish the above-stated object, and have completed the present invention.

More specifically, the present invention is as shown below.

[1] An infrared transmissive protective cover, comprising a light transmission section, wherein
the light transmission section is made of a resin sheet containing a resin composition, and
a total light transmittance of the light transmission section in a visible light region is 70% or more, and an average infrared transmittance of the light transmission section in a wavelength range of 8 to 14 $\mu$m is 5% or more ,
a thickness of the light transmission section is from 0.2 to 3 mm, and
a falling weight impact strength of the light transmission section is 1 J or more
[2] The infrared transmissive protective cover according to the item [1], wherein
the average infrared transmittance of the light transmission section in the wavelength range of 8 to 14 $\mu$m is 20% or more.
[3] The infrared transmissive protective cover according to the item [1] or [2], wherein
a haze value of the light transmission section is 40% or less.
[4] The infrared transmissive protective cover according to any one of the items [1] to [3], wherein
the resin composition comprises a thermoplastic resin.
[5] The infrared transmissive protective cover according to the item [4], wherein
the thermoplastic resin is a polyolefin resin.

[6] The infrared transmissive protective cover according to the item [5], wherein
a density of the polyolefin resin is from 925 to 945 kg/m$^3$.
[7] The infrared transmissive protective cover according to the item [5], wherein
an intrinsic viscosity of the polyolefin resin is 7 dL/g or more.
[8] The infrared transmissive protective cover according to any one of the items [1] to [7], comprising:

the light transmission section; and
a frame body that supports the light transmission section.

[9] A method for manufacturing the infrared transmissive protective cover according to any one of the items [1] to [8], the method comprising
a molding step of obtaining the resin sheet from the resin composition by any method selected from the group consisting of an extrusion method, an injection molding method, a press molding method, and a skiving method.
[10] The method for manufacturing the infrared transmissive protective cover according to the item [9], the method further comprising
a step of stretching, rolling or extending the resin sheet at a temperature less than a melting point of the resin composition after the molding step.
[11] A method for monitoring a heating element protected with the infrared transmissive protective cover according to any one of the items [1] to [8] by visual observation and by using infrared thermography.

Advantageous Effects of the Invention

According to the present invention, it becomes possible to provide a practical infrared transmissive protective cover capable of detecting abnormalities such as a heating abnormality of an internal heating element by visual observation and by using infrared rays.

Brief Description of Drawings

Figure 1 is a front view showing one example of an infrared transmissive protective cover of the present embodiment.
Figure 2 is a side view showing the infrared transmissive protective cover of the present embodiment.
Figure 3 is a schematic sectional side view showing one example in a case where the infrared transmissive protective cover of the present embodiment is placed on a terminal block.
Figure 4 is a schematic sectional side view showing the infrared transmissive protective cover of Figure 3 immediately before the cover has been placed on the terminal block.
Figure 5 is a schematic sectional side view showing another example in a case where the infrared transmissive protective cover of the present embodiment is placed on the terminal block.
Figure 6 is a schematic sectional side view showing the infrared transmissive protective cover of Figure 5 which is placed on the terminal block.

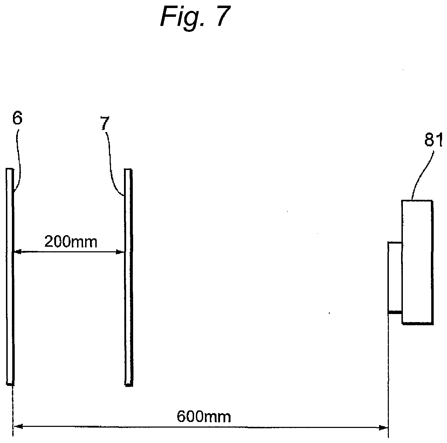

Figure 7 is a conceptual view used for explaining a field inspection by visual observation performed in an Example.
Figure 8 is a photograph taken for showing placement of an apparatus for the field inspection performed in the Example.
Figure 9 is a conceptual view used for explaining a field inspection using infrared thermography performed in the Example.
Figure 10 is a photograph of a character table used for visibility check by visual observation in the Example, the photograph being taken in a state where a right-side area of the character table is covered with the infrared transmissive protective cover of Example 8.
Figure 11 is a thermal image photograph showing a field inspection (without the protective cover) by the infrared thermography in Example 8.
Figure 12 is a thermal image photograph showing a field inspection (with the protective cover) by the infrared thermography in Example 8.
Figure 13 is a thermal image photograph showing a field inspection (with the protective cover and with correction) by the infrared thermography in Example 8.

Modes for Carrying Out the Invention

Hereinafter, a mode for implementing the present invention (hereinafter simply referred to as "the present embodiment") will be explained in detail with reference to the drawings where necessary. It should be understood that the following embodiment is only illustrative for explanation of the present invention and is not intended to limit the present invention to the following description. The present invention can appropriately be modified and implemented within the scope of the invention. It is to be noted that unless otherwise specified, positional relations throughout the drawings, such as relations between the vertical and horizontal positions and between the left and right, shall be based on the positional relations shown in the drawings. It should further be understood that the dimensional ratio of the drawings is not limited to the ratio shown in the drawings.

An infrared transmissive protective cover (hereinafter simply referred to as the "protective cover") of the present embodiment has a light transmission section, the light transmission section is made of a resin sheet containing a resin composition, and a total light transmittance of the light transmission section in a visible light region is 70% or more, and an average infrared transmittance in a wavelength range of 8 to 14 $\mu$m is 5% or more.

The total light transmittance of the light transmission section in the visible light region is a value measured according to JIS K 7361-1:1997. The total light transmittance of the light transmission section in the visible light region is 70% or more, preferably 80% or more, and more preferably 85% or more. When the total light transmittance is less than 70%, the transparency of the protective cover with respect to visible rays becomes poor. This makes it difficult to see a subject that is to be detected through visible light and thereby causes low visibility, so that checking the state inside the protective cover becomes difficult.

The average infrared transmittance of the light transmission section refers to an average value of infrared transmittance in a wavelength region of 8 to 14 $\mu$m. In calculation of the average value of the infrared transmittance, a material forming the light transmission section is used as a test piece, a transmittance is measured using an infrared spectrophotometer by a transmission method under the conditions of resolution being 4 cm$^{-1}$, an integration count being 32, and a wavelength region being from 8 to 14 $\mu$m (wavenumber region being from 1250 to 714 cm$^{-1}$), values acquired from the infrared transmittance for every 1-cm$^{-1}$ area obtained in the range of the above wavelength region are calculated, and the obtained values are averaged and used as an infrared transmittance. Specifically, the infrared transmittance can be obtained by measuring the infrared transmittance for every 1-cm$^{-1}$ area in the range of the wavelength region of 1250 to 714 cm$^{-1}$, adding all the resultant values and dividing the added value by the total number of data pieces.

The average infrared transmittance of the light transmission section in the wavelength range of 8 to 14 $\mu$m is 5% or more, preferably 10% or more, more preferably 20% or more, and still more preferably 30% or more. Accordingly, identification and confirmation using a sensor such as infrared thermography sensors become easier.

The haze value of the light transmission section is preferably 40% or less. The haze value is also referred to as cloudiness, which is an important index on visibility (remote visibility) in the case of seeing a distant subject. The haze value can be measured by a method according to JIS K 7136:2000. The haze value is preferably 40% or less, more preferably 30% or less, still more preferably 20% or less, and yet more preferably 10% or less. By employing the above-mentioned value as the haze value of the light transmission section, cloudiness of the light transmission section can be suppressed, and thereby much superior visibility can be achieved.

Examples of the haze value may include an external haze value relating to surface scattering and an internal haze value indicating transparency intrinsic to materials. A haze value obtained by adding these values is defined as a total haze value. A ratio (A/B) of the internal haze value (A) to the total haze value (B) of the light transmission section is preferably 0.5 or more, more preferably 0.7 or more, and still more preferably 0.8 or more.

The internal haze is a haze intrinsic to the materials attributed to the internal structure of the light transmission section, whereas the total haze is a haze including external surface scattering attributed to surface smoothness. As the ratio (A/B) is closer to 1 (as the total haze value is closer to the internal haze value), the visibility of the light transmission section can further be enhanced and excellent remote visibility can be obtained. The remote visibility herein refers to a characteristic that a distant place can visually be confirmed by visual observation.

It is to be noted that excellent transparency stated in the present embodiment refers to the characteristics that the transmittance to visible rays is high and the haze value is low.

The thickness of the light transmission section, is 0.2 to 3 mm, more preferably 0.3 to 2 mm, and still more preferably 0.5 to 1.5 mm from a viewpoint of a balance between the total light transmittance, the average infrared transmittance, and the haze value in a visible light region as well as from a viewpoint of strength. By setting the thickness of the light transmission section to 3 mm or less, the above-mentioned transparency to visible rays and infrared rays as well as the haze value are turned into further better values, so that the visibility by visual observation and detectability by infrared sensors can further be enhanced. By setting the thickness of the light transmission section to 0.2 mm or more, much superior mechanical strength can be imparted to the protective cover.

The falling weight impact strength of the light transmission section is 1 J or more, more preferably 2 J or more, and still more preferably 5 J or more. When the light transmission section has a falling weight impact strength of 1 J or more, the protective cover is provided with the strength high enough to prevent the protective cover from being destroyed even when a tool, such as drivers, comes into contact with the protective cover during maintenance operation of distribution boards, switchboards and the like that are covered with the protective cover. The falling weight impact strength is a value of striking energy generated by giving an impact on a test piece at room temperature by falling a striker having a diameter of 10 mm$\phi$ and a striker weight of 3.2 kgf at a falling speed of 5.9 m/s. The falling weight impact strength can be measured by a method described in later-described Examples.

A resin composition used for the light transmission section preferably includes a thermoplastic resin. Since the thermoplastic resin can be molded by various molding methods, such as extrusion, injection molding, compression molding, and blow molding, it is easy to form the light transmission section into a desired shape.

The thermoplastic resin is preferably a polyolefin resin. Generally, when resin is irradiated with an infrared ray, characteristic absorption occurs in the wavelength of the irradiated infrared ray, and thereby the transmission amount of the infrared ray tends to decrease in proportion to the kind and the amount of a functional group or the like in molecular chains that constitute resin. From this viewpoint, a polyolefin resin that is large in transmission amount of infrared rays is preferable.

Although the density of a polyolefin resin is not particularly limited, a lower limit thereof is preferably 880 kg/m$^3$, and more preferably 910 kg/m$^3$. Setting the density of a polyolefin resin to 880 kg/m$^3$ or more makes it possible to acquire excellent rigidity. Moreover, an upper limit of the density of a polyolefin resin is preferably 960 kg/m$^3$, more preferably 950 kg/m$^3$, and still more preferably 945 kg/m$^3$. Setting the density of a polyolefin resin to 960 kg/m$^3$ or less increases a ratio occupied by an amorphous region, as a result of which the haze value can be made still smaller while excellent rigidity can be maintained. When higher transparency (light transparency to visible rays, remote visibility, etc.) is demanded in particular, the density of a polyolefin resin is preferably 925 to 945 kg/m$^3$, and more preferably 931 to 945 kg/m$^3$. The density of a polyolefin resin can be measured according to JIS K 7112:1999.

The intrinsic viscosity of a polyolefin resin in decalin solution at 135°C is not particularly limited. When importance is put on the impact strength, the intrinsic viscosity is preferably 7 dL/g or more, and more preferably 10 dL/g or more. Setting the intrinsic viscosity of a polyolefin resin to the above range makes it possible to obtain higher impact strength. When a balance of impact strength and molding workability is demanded in particular, the intrinsic viscosity of a polyolefin resin is preferably 7 to 20 dL/g. The intrinsic viscosity can be measured by a solution viscosity method. Specifically, a 20-mg sample is dissolved into 20-mL decalin (decahydronaphthalene), the resultant solution is put into a thermostatic oven at 135°C, and falling time (ts) between gauge lines is measured by using an Ubbelohde-type viscometer. Measurement of falling time (tb) in the case of decalin only, that is, decalin without a sample, is also performed as a blank test. Based on Formula (1) shown below, a specific viscosity ($\eta$sp/C) of the sample is plotted and is extrapolated to the zero concentration to obtain intrinsic viscosity ($\eta$:I.V).

$$\eta sp/C = (ts/tb - 1)/0.1 \qquad (1)$$

Preferable examples of a polyolefin resin may include, for example, polyethylene resin, polypropylene resin, polybutadiene resin, cycloolefin resin, butene-1 resin, ethylene propylene rubber, and products of hydrogenation thereof. Of these, polyethylene resin and polypropylene resin are more preferable, and polyethylene resin is still more preferable from a viewpoint of infrared transparency in particular. Since polyethylene resin has simpler structure and contains a few functional groups that absorb infrared rays, polyethylene resin transmits a large amount of infrared rays. Polyethylene resin, which is known as half-crystalline resin, generally has a crystalline region and an amorphous region. Accordingly, due to a difference in refractive index between these regions, polyethylene resin tends to be non-transparent (clouded). In order to acquire light transparency to visible rays in the present embodiment, it is preferable to lower the crystallinity of polyethylene resin as much as possible. From this viewpoint, polyethylene copolymers are preferable. It is to be noted that infrared absorption may increase depending on the kind and the amount of comonomers for use in polyethylene copolymers. From this viewpoint, the comonomer to be used is preferably propylene and 1-butene.

Polyethylene resin may herein be a homopolymer of ethylene, or may be a copolymer of ethylene and another comonomer copolymerizable with ethylene (e.g., $\alpha$-olefin such as propylene, 1-butene, 1-hexene, and 1-octene, vinyl acetate, vinyl alcohol, etc.). Specific examples of polyethylene resin may include high-density polyethylene (HDPE), middle-density polyethylene (MDPE), low-density polyethylene (LDPE), linear low-density polyethylene (LLDPE), very low-density polyethylene (VLDPE), ultrahigh molecular weight polyethylene (UHMWPE), and crosslinked polyethylene (PEX). These polyethylene resins may be used singly or in combination of two or more.

From the viewpoint of further enhancing the impact strength of the protective cover, polyethylene resin is preferably a polyethylene resin having a narrow molecular weight distribution. More specifically, the molecular weight distribution (Mw/Mn) of polyethylene resin obtained by gel permeation chromatography (GPC) measurement is preferably 10 or less, more preferably 8 or less, and still more preferably 6 or less. Examples of a method for obtaining polyethylene resin having a narrow molecular weight distribution include a method for polymerization by using a single-site catalyst such as metallocene-based catalysts. In the GPC as mentioned herein, measurement may be performed at 140°C by using, for example, "150C ALC/GPC" manufactured by Waters Corp., "AT-807S" manufactured by Shodex, and "TSK-gelGMH-H6" manufactured by Tosoh Corp. connected in series as a column, and trichlorobenzene containing a 10-ppm antioxidant "IRGANOX 1010" as a solvent.

From a viewpoint of further enhancing physical properties, such as impact strength, of the protective cover, it is preferable to use polyethylene resin that is a high molecular weight polymer. More specifically, a melt flow rate (MFR) of polyethylene resin is preferably 20 g/10 minutes or less, more preferably 10 g/10 minutes or less, and still more preferably 5 g/10 minutes or less. With the MFR being 20 g/10 minutes or less, moldability of the resin composition becomes much superior and physical properties such as impact strength is further enhanced. The MFR is measured at a temperature of 190°C with a load of 2.16 kgf according to JIS K 7210:1999.

Polypropylene resin may herein be a homopolymer of propylene, or may be a copolymer of propylene and another comonomer copolymerizable with propylene (e.g., $\alpha$-olefin such as ethylene, 1-butene, 1-hexene and 1-octene; vinyl acetate; vinyl alcohol; etc.).

Specific examples of polypropylene resin may include: a propylene homopolymer; a copolymer of propylene and one or more kinds of monomers selected from the group consisting of ethylene and $C_{4-20}$ $\alpha$-olefin; and mixtures thereof. Of these, a propylene homopolymer, a propylene-ethylene copolymer, a propylene-1-butene copolymer, a propylene-1-pentene copolymer, a propylene-1-hexene copolymer, a propylene-1-octene copolymer, a propylene-ethylene-1-butene copolymer, and a propylene-ethylene-1-hexene copolymer are preferable. When polypropylene resin is a copolymer of propylene and one or more kinds of monomers selected from the group consisting of ethylene and $C_{4-20}$ $\alpha$-olefin, it may be a random copolymer or may be a block copolymer. These polypropylene resins may be used singly or in combination of two or more.

When a polyolefin resin, such as the above-stated polyethylene resin and polypropylene resin, is a copolymer, a coupling form thereof is not particularly limited, so that it may be a random copolymer or may be a block copolymer.

It is to be noted that in the range where the effect of the present embodiment can be obtained, other additives (such as weather resistance agents, thermostabilizers, and lubricants) in addition to the above-mentioned resins can be added to the resin composition. However, it is preferable that the light transmission section substantially be a resin sheet made only of a polyolefin resin. Specifically, the content of a polyolefin resin in the resin composition is preferably 90% by mass or more, more preferably 95% by mass or more, and still more preferably 100% by mass. It is preferable in particular, that the light transmission section substantially be a resin sheet made only of polyethylene resin. In this case, more specifically, the content of polyethylene resin in the resin composition is preferably 90% by mass or more, more preferably 95% by mass or more, and still more preferably 100% by mass.

The protective cover of this embodiment may be a protective cover having the above-mentioned light transmission section, and may be a protective cover formed only from the light transmission section, for example. From a viewpoint of strength or the like, the protective cover of the present embodiment preferably includes the aforementioned light transmission section and a frame body that supports the light transmission section. Satisfactory strength can be imparted to the protective cover by supporting the light transmission section using the frame body.

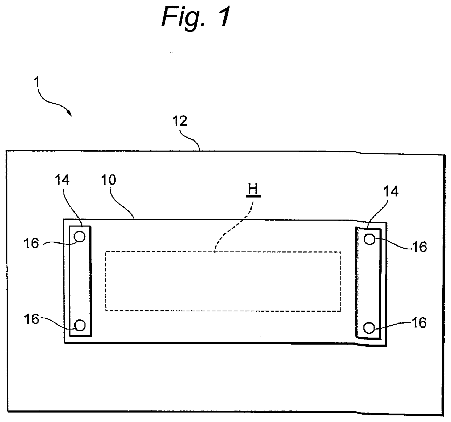

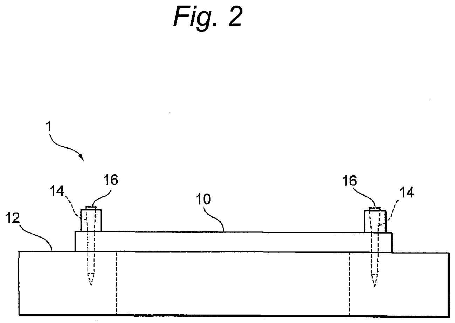

Figure 1 is a front view showing one example of the protective cover of the present embodiment, and Figure 2 is a side view of the present embodiment. A protective cover 1 has a light transmission section 10 formed from a resin sheet. The light transmission section 10 is supported by a frame body 12 that is formed from a base material, and is interposed between the frame body 12 and a pressing plate 14 so as to be fixed. The pressing plate 14 is fixed to the frame body 12 with a small screw 16. The frame body 12 has an opening H, which is a region corresponding to the light transmission section 10. A target can be monitored by visual observation and by using infrared thermography through the opening H.

Although the material of the frame body 12 is not particularly limited, examples of the material may include plastic and metal such as aluminum and iron. Of these, plastic is preferable in terms of insulation. More preferable examples of plastic may include acrylic resin, polycarbonate resin, polyethylene terephthalate resin, polyvinyl chloride resin, polyacetal resin, polyethylene resin, and polyamide resin. Of these, acrylic resin is preferable in terms of rigidity.

The shape of the frame body 12 is not particularly limited, and therefore, the frame body 12 may appropriately have a suitable shape and dimension in accordance with the form and size of members (terminals, etc.) which should be protected. For example, when plastic is used as a material of the above-mentioned frame body, a thickness, a width, and a length of the frame body may be determined in terms of mechanical strength, and the thickness of the frame body is preferably 4 mm or more.

For example, when acrylic resin is used as a material of the frame body 12, an acrylic resin plate (acrylic plate) may be cut and processed to have an opening H so as to form the frame body 12, the light transmission section 10 that is a resin sheet may be bonded so as to cover the opening H, and then a periphery thereof may be fixed with the pressing plate 14. At the time of fixing a member such as the light transmission section 10, fixing may be implemented with such fixtures as the small screw 16 and bolts, though from a viewpoint of preventing electric shock, it is preferable not to use metallic materials as much as possible.

In order to protect components such as high-voltage terminals, the protective cover 1 may be used as a protective cover that protects the entire panel such as distribution boards, and may be used as a protective cover that protects only a portion that requires monitoring by infrared rays. In that case, it is preferable that the light transmission section be a protective cover openable/closeable by sliding (unshown). Using such a sliding-type protective cover makes it possible to prevent contact between the terminals and the light transmission section, and also to directly check the terminals by visual observation.

The protective cover 1 may have parts other than the aforementioned light transmission section 10 and the frame body 12. It is preferable that the parts be made of insulating materials from a viewpoint of preventing an electric shock.

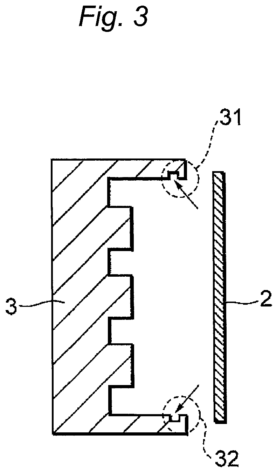

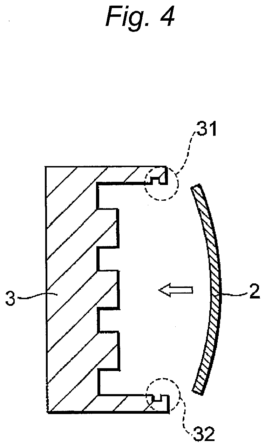

A description is now given of one example of a method for using the protective cover of the present embodiment. Figure 3 is a schematic sectional side view showing one example in a case where a terminal block is protected with use of the protective cover of the present embodiment. Figure 4 is a side view showing the protective cover of Figure 3 immediately before the cover is has been placed on the terminal block. The protective cover 2 is set onto the terminal block 3 by inserting both ends of the protective cover 2 into insertion grooves 31 and 32 of the terminal block 3. When the protective cover is used for one for a low-voltage terminal block in particular, use of the protective cover 2 being inserted into the terminal block 3 is preferable as shown in Figures 3 and 4. According to the present embodiment, when both the ends of the protective cover 2 are inserted into the insertion grooves 31 and 32 of the terminal block 3, neither whitening nor generation of cracks occurs even with a stress being applied to the protective cover 2. This tendency becomes notable when the resin sheet for use in the light transmission section of the protective cover 2 includes a polyolefin resin, in particular. Thus, the protective cover of the present embodiment can be mounted on terminal blocks of various forms.

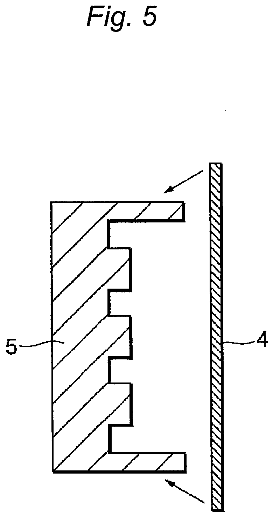

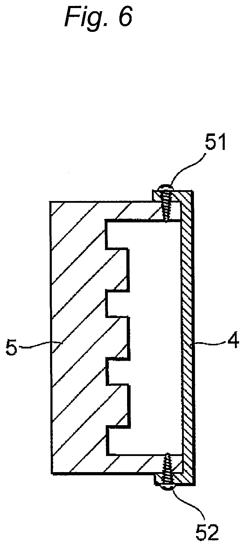

Figure 5 is a schematic sectional side view showing another example in a case where the protective cover of the present embodiment is placed on the terminal block. Figure 6 is a schematic sectional side view showing the protective cover of Figure 5 placed on the terminal block. After an upper portion (a right-hand side in Figures 5 and 6) of a terminal block 5 is covered with the protective cover 4, both the ends of the protective cover 4 are folded and fixed with screws 51 and 52. It is to be noted that the screws 51 and 52 may be small screws. It is to be noted that the protective cover 4 may be folded (see, for example, Figure 6) in advance, and then be placed on the terminal block 5.

A description is now given of one example of a method for manufacturing the protective cover of the present embodiment. Examples of preferable manufacturing methods may include a manufacturing method including a molding step of obtaining the resin sheet from the resin composition by any method selected from the group consisting of an extrusion method, an injection molding method, a press molding method, and a skiving method.

Hereinafter, a detailed description is given of, as one of the preferable examples, a case where a polyolefin resin such as polyethylene resin is molded into a resin sheet and the resin sheet is used as a light transmission section.

A polyolefin resin, such as polyethylene resin, can be molded into a sheet by a generally used molding method. Examples of preferable methods thereof may include: extrusion performed by mounting a die with a slit in a desired form at the top end of an extruder; injection molding for injecting and thereby inserting molten resin into a metal mold that is processed into a desired form; press molding for spreading resin inside a metal mold having a desired form, melt-heating polyolefin resin under predetermined temperature and pressure, and then cooling the polyolefin resin under pressure; and so-called skiving that is to skive a molded article that has been compression-molded into a cylindrical shape in advance, into thin films with a desired thickness with a cutting blade.

In the present embodiment, it is preferable to further include a step of stretching, rolling or extending the resin sheet at a temperature less than a melting point after the molding step. This makes it possible to make a resin sheet having an orientation, and to thereby make a protective cover having much superior mechanical strength and transparency.

Examples of a stretching method may include a method for clamping and uniaxially or biaxially stretching an end portion.

Examples of a rolling method may include, for example, a method for rolling with one pair or more rolls which rotate in the directions opposite to each other.

In the case where a thick resin sheet is desired in particular, rolling with use of a rolling mill is preferable. Rolling may be performed in one step and may be performed as multistep rolling that performs rolling in two or more steps. For example, when multistep rolling is performed, rolling in multi-steps may be performed in succession, a material that has been rolled once is wound up, and then is passed through the same rolling mill a plurality of times, or the once-rolled material may be passed through another rolling mill for multistage rolling.

Examples of an extending method may include, for example, a method for extending a heated sheet in the directions of two axes in a plane under pressure with use of a pressing disk or the like.

Hereinafter, a description will be given of the case of stretching. Unless otherwise specified, the conditions described below are also applicable to the case of rolling and extending.

An upper limit of stretching temperature is preferably less than a melting point of the resin composition, more preferably a melting point minus 3°C, and still more preferably a melting point minus 5°C. A lower limit of stretching temperature is preferably a melting point minus 60°C, more preferably a melting point minus 30°C, and still more preferably a melting point minus 10°C. The melting point can be measured by differential scanning calorimetry (DSC) by a method according to JIS K 7121:1987, and an apex of a peak is adopted as a melting point. When a plurality of peaks are confirmed, a peak value on the lowermost temperature side is adopted as a melting point.

When the stretching temperature is less than a melting point, recrystallization in a cooling process after stretching can effectively be suppressed, and a phenomenon of returning to a cloudy state can be suppressed. As a result, transparency of the sheet can be enhanced more. The reason why the transparency is enhanced by performing the stretching step at the temperature less than a melting point is unclear but the following presumption can be considered. That is, at the temperature less than a melting point, a sheet is stretched while the crystal structure remains. Accordingly, internal crystal structure is destroyed due to stretching deformation and a crystal size is reduced to equal to or smaller than the wavelength of visible rays, which presumably enhances transparency of visible rays (the operations of the present embodiment are not limited thereto). At the same time, since the sheet is oriented by stretching, improvement in mechanical physical properties, such as shock resistance, is also expectable. The stretching step may be implemented by uniaxial stretching or may be performed by biaxial stretching.

A stretching ratio of the thickness of the polyolefin resin sheet is preferably 1.3 times or more, more preferably twice or more, and still more preferably 3 times or more. The stretching ratio herein refers to a ratio of a thickness before stretching to a thickness after stretching (thickness before stretching / thickness after stretching). By using the thus obtained polyolefin resin sheet as the light transmission section, much superior transparency to both the aforementioned visible rays and infrared rays can be demonstrated. It is to be noted that the stretching ratio can be controlled by adjusting a molecular weight, a density and a melting point of a raw material to be selected. In the case of performing the stretching step, among polyolefin resins, polyethylene resin is preferable, and high-density polyethylene (HDPE) resin and ultrahigh molecular weight polyethylene (UHMWPE) resin are more preferable, in particular. In the case of high density polyethylene (HDPE) resin in particular, the stretching ratio thereof is preferably 3 times or more, more preferably 4.5 times or more, and still more preferably 5 times or more. In the case of ultrahigh molecular weight polyethylene (UHMWPE) resin, the stretching ratio thereof is preferably 3.3 times or more, more preferably 3.7 times or more, still more preferably 3.9 times or more, and yet more preferably 4.8 times or more.

In the case of forming a resin sheet by rolling, the above-mentioned stretching temperature (rolling temperature) as well as a roll gap width, a roll rotation speed, and a take-up speed after rolling are controlled, so that a resin sheet of an arbitrary stretching ratio (rolling ratio) can be obtained. These conditions can be selected in accordance with a composition and a thickness of an original fabric sheet, a desired stretching ratio (rolling ratio) and the like.

In the case of forming a resin sheet by extending, the above-mentioned stretching temperature (extending temperature) as well as a pressing speed, a metal mold thickness of the pressing disk and a pressing pressure are controlled, so that a resin sheet of an arbitrary stretching ratio (extending ratio) can be obtained. These conditions can be selected in accordance with a composition and a thickness of an original fabric sheet, a desired stretching ratio (extending ratio) and the like.

These characteristics can be acquired by controlling the crystal structure with the orientation provided at the time of stretching in the present embodiment. The orientation provided at the time of stretching can be expressed with a stretching orientation parameter f (hereinafter abbreviated as "f"), which can be obtained by wide-angle X-ray scattering (WAXS) measurement that can be expressed with Formula (2) shown below:

$$f = 1 - (\Delta/360) \qquad (2)$$

where $\Delta$ is a half width of a peak obtained in the following method.

Azimuthal dependency of a peak intensity derived from a (110) plane present in $2\theta = 21.2°$ obtained by WAXS measurement is calculated. Specifically, a range of $21.0° < 2\theta < 22.0°$ is integrated, a relationship diagram between an azimuth and a normalized scattering intensity is obtained, and an obtainable half width of a peak ($\Delta$) is determined.

(One example of WAXS measurement conditions)

A molded sheet is used as a test piece and "Nano Viewer" manufactured by Rigaku Corp. is used to conduct measurement under the following conditions. As an optical system, a point collimation (1st: 0.4 mm$\phi$, 2nd: 0.2 mm, guard: 0.6 mm$\phi$) is used to emit an X-ray from a sheet normal line direction (Through View). As a detector, an imaging plate is used with a camera length of 78.8 mm and with an irradiation time of 15 minutes for measurement, a WAXS profile scattering image is acquired.

A value f is preferably 0.880 or more, more preferably 0.900 or more, and still more preferably 0.920 or more. If the value f is 0.880 or more, transparency of the protective cover in a visible light region is excellent, so that visual observation of defects and deteriorated states of a subject can easily be implemented. Further, the value f being 0.880 or more is also desirable from the viewpoint that the protective cover has excellent impact strength. The value f can be controlled by the aforementioned stretching temperature and the stretching ratio at the time of stretching, and in the case of rolling in particular, a roll gap width, a roll temperature, an original fabric sheet temperature before rolling, a temperature difference between a sheet and roll, or a thickness ratio (rolling ratio) between an original fabric sheet and a rolled sheet.

In order to improve the transparency of the sheet by stretching, a method for forming an original fabric sheet is also important. A desirable method for forming an original fabric sheet varies depending on the kind of resin to be used. For example, when an original fabric sheet is formed by extrusion of high-molecular weight polymers such as ultrahigh molecular weight polyethylene (UHMWPE), the surface of the sheet is roughened due to high viscosity, which may deteriorate the transparency after stretching. Accordingly, in the case of using polyethylene resin of high molecular weight polymers, a skived sheet that is formed by skiving a cylindrically molded article that has been formed by compression molding, into thin films with a cutting blade, is preferable as an original fabric sheet. Ultrahigh molecular weight polyethylene (UHMWPE) preferably has an intrinsic viscosity of 7 dL/g or more.

High-density polyethylene (HDPE) and polyethylene resin with a low molecular weight have high density, and therefore, if a skived sheet is formed as an original fabric sheet from a compression-molded article, the sheet bears so-called knife marks, and the like as skiving is not efficiently performed due to high rigidity of the molded article. As a result, the surface of the sheet is roughened and this may deteriorate the transparency after stretching. From this viewpoint, in the case where the original fabric sheet is formed by using high-density polyethylene (HDPE) and polyethylene resin with a relatively low molecular weight as a raw material, an extruded sheet is preferable as an original fabric sheet. High-density polyethylene (HDPE) preferably has a density of 931 to 945 kg/m$^3$.

In the present embodiment, any resin composition can be used as long as a resin sheet can be formed into a sheet with a total light transmittance of the light transmission section in the visible light region being 70% or more and an average infrared transmittance in the wavelength range of 8 to 14 $\mu$m being 5% or more. Of the above-mentioned resin compositions, in the case of ultrahigh molecular weight polyethylene (UHMWPE), other low crystal and low density polyethylene (LDPE) materials and the like, for example, there is a tendency that a resin sheet with an excellent balance between the total light transmittance and the average infrared transmittance can efficiently be obtained even only through steps by the extrusion method, the injection molding method, the press molding method, and the skiving method. In the case of high-density polyethylene (HDPE) and the like, there is a tendency that a resin sheet much superior in the total light transmittance and the average infrared transmittance can efficiently be obtained by performing the stretching step in addition to steps by the extrusion method, the injection molding method, the press molding method, and the skiving method.

Although the infrared transmissive protective cover of the present embodiment can be manufactured from a monolayer resin sheet, it may also be manufactured, unless the effects of the present embodiment are compromised, by laminating with other sheets, bonding a film on one side or both sides of the resin sheet, or applying a coating material and the like on one side or both sides of the resin sheet.

By utilizing the aforementioned characteristics, the protective cover of the present embodiment may suitably be used as such purpose as a protective cover in electric installations, e.g., as a protective cover for connection terminals in a distribution board.

Since the protective cover of the present embodiment has excellent transparency to both visible rays and infrared rays, it becomes possible to monitor the state of connection terminals and the like, by using both visual observation and infrared rays. Moreover, since a resin is used, sufficient insulation can also be secured. Consequently, the state of connection terminals can be checked while electricity is being supplied, it is thereby not necessary to stop the installations and apparatuses of the stages subsequent to the distribution board, which brings out economic advantages. While the state of connection terminals and other components is monitored by visual observation, Joule's heat generated from electric connection terminals at the time of operation can also be detected with infrared rays. Further, automation can be achieved, as a result of which power saving can also be achieved. Moreover, since the protective cover does not need to be removed, security of operators can also be secured.

The protective cover of the present embodiment can suitably be used for monitoring abnormalities such as abnormal heating in the terminal block within a distribution board or the like. A monitoring method with use of the protective cover is a method for monitoring a heating element protected by the protective cover by visual observation and by using infrared thermography. The heating element herein refers to a monitoring object (target). Examples thereof include electric members such as terminal blocks and molded case circuit breakers (circuit breakers). According to the monitoring method of the present embodiment, monitoring a heating element by visual observation and by using infrared thermography can be performed without cutting electric supply to the electric members such as terminal blocks and molded case circuit breakers (circuit breakers) that are protected by the protective cover. To be specific, it becomes possible to visually observe the states including the operating state of electric members, such as terminal blocks and molded case circuit breakers, and the connection state of joint sections, as well as the presence of discoloring and deformation or the like. At the same time, by using infrared thermography, temperature increase, due to such causes as abnormal heating in joint sections and abnormal heating at contact points of the circuit breakers can safely and effectively be monitored as a temperature difference from ambient temperature. It is to be noted that such timing as confirmation by visual observation and confirmation by infrared thermography is not particularly limited. These observations may be conducted at the same time, or any one of the methods may be used first for confirmation and the other method may then be used for confirmation. As for monitoring, it is preferable to monitor the heating element in real time. Thereby, the state of the heating element can be monitored easily and continuously while installations and the apparatuses placed downstream of the stages subsequent to the distribution board are continuously operated. Therefore, real-time monitoring is desirable from a viewpoint of power saving and securing the safety of operators.

Examples

Hereinafter, the present invention will be described in more detail with Examples, though the present invention is not limited to the following Examples in any sense.

(1) Density ($\rho$: kg/m$^3$)

Measurement was conducted by a density gradient tube method (23°C) according to JIS K 7112:1999.

(2) Melt flow rate (MFR: g/10 minutes)

In the case of polyethylene (PE) and polypropylene (PP), measurement was conducted according to JIS K 7210:1999.

(3) Intrinsic viscosity (dL/g)

The viscosity of ultrahigh molecular weight polyethylene was measured by the solution viscosity method. A 20-mg sample was put into a 20-mL decalin (decahydronaphthalene), and then stirred for 2 hours at 150°C to dissolve the sample. The solution was then put into a thermostatic oven at 135°C, and falling time ($t_s$) between gauge lines was measured by using an Ubbelohde-type viscometer. It is to be noted that measurement of falling time ($t_b$) in the case with decalin only without a sample, tests were performed as a blank. Based on Formula (3) shown below, specific viscosity ($\eta_{sp}$/C) of the sample was plotted and was extrapolated to the zero concentration to obtain intrinsic viscosity ($\eta$: I.V).

$$\eta_{sp}/C = (t_s/t_b - 1) / 0.1 \qquad (3)$$

(4) Melting point (°C)

The melting point was measured according to JIS K 7121:1987. Specifically, measurement was conducted by the following operation. An 8-mg sample was weighed, put and enclosed in an aluminum pan. Then, the sample temperature was increased from 50°C to 180°C at a heating rate of 10°C/minute, and then held for 5 minutes. The temperature was cooled to 50°C at a cooling rate of 10°C/minute, and then held for 5 minutes. The sample temperature was then increased again to 180°C at a heating rate of 10°C/minute. The temperature of an endothermic peak accompanying melting at the second temperature increase was measured using a thermogravimetric measuring apparatus ("Pyris 1 DSC" manufactured by PerkinElmer, Inc.), and was used as a melting point.

(5) Molding method

(5-1) Molding of press sheet

A resin raw material was compression-molded by using a metal mold having a flat opening with 200 mm long, 200 mm wide, and (0.5 mm or 1.0 mm) thick, according to JIS K 6936-2:2007 so as to form a press sheet. Specifically, the press sheet was formed by the following method.

A 0.1-mm thick aluminum plate was put on a 5-mm thick smooth iron plate, a 50-$\mu$m thick polyethylene terephthalate film (manufactured by Toray Industries, Inc., trade name "Lumirror") was further placed thereon, and the above-mentioned metal mold (metal mold having an opening) was then put thereon. A sample was placed into that opening. On top thereof, a polyethylene terephthalate film, the above-mentioned aluminum plate, and the above-mentioned iron plate were put in this order. The resultant article was put into a compression molding machine ("SFA-37" manufactured by Shinto Metal Industries Corp.) whose temperature was adjusted to 210°C. The article was heated at 210°C and pressed at 5 MPa for 5 minutes, and after degassing, the article was pressed at 10 MPa for 25 minutes. After pressurization was completed, the sample was taken out and was put into the compression molding machine ("SFA-37" made by Shinto Metal Industries Corp.) whose temperature was adjusted to 25°C. The article was cooled therein at a cooling rate of 15 ± 2°C/minutes while being pressurized for 5 minutes at the pressure of 10 MPa. At the time of cooling, a fixed amount of cooling water was supplied so as to adjust the cooling rate.

(5-2) Forming of skived sheet

Ultrahigh molecular weight polyethylene powder was fed into an opened doughnut-shaped metal mold with an external diameter of 600 mmϕ and an inner diameter of 90 mmϕ so as to achieve a final thickness of about 130 mm. Internal air was exhausted for 30 minutes at about 10 MPa. Then, the metal mold was heated for 13 hours under the pressure of about 9 MPa and temperature of about 140-145°C. Further, the metal mold was left for about 7 hours while the pressure was held at about 9 MPa for cooling. Next, a doughnut-shape molded article taken out from the metal mold was left for 2 days or more at room temperature so that internal heat thereof was gradually removed and cooled. Then, the doughnut-shape molded article was fixed onto a skiving machine and skived to obtain a 1-4-mm thick skived sheet.

(5-3) Forming of rolled sheet

The skived sheet or the press sheet was rolled by using rolling mill with a roll diameter of 300 mmϕ and a roll width of 500 mm to be adjusted to an arbitrarily gap, and the sheet was rolled at a roll rotation speed of 1 m/minute. Rolling was conducted with a roll temperature of 120°C. The rolled sheet that had fed out of the rolling mill was taken up at a changed take-up speed and wound, while a tension of 200 N or more was applied thereto and while a tension controller was monitored. The wound sheet was left for several hours at room temperature for cooling, by which a 0.3-1.2-mm thick rolled sheet was obtained.

(6) Sheet thickness

The sheet thickness was obtained by measuring a thickness value with use of a micro meter ("395-541: BMD-25DM" manufactured by Mitutoyo Corp.), to two decimal places and by rounding off to one decimal place. The stretching ratio was calculated by rounding off the measured thickness to one decimal place.

(7) Haze

The molded sheet was cut into a 35 mm × 50 mm test piece to conduct measurement according to JIS K 7136:2000. Measurement was conducted by using a measuring apparatus "HazeMeter NDH2000" manufactured by Nippon Denshoku Industries Co., Ltd.

(8) Total light transmittance

The molded sheet was cut into a 35 mm × 50 mm test piece to conduct measurement according to JIS K 7361-1:1997. Measurement was conducted by using the measuring apparatus "HazeMeter NDH2000" manufactured by Nippon Denshoku Industries Co., Ltd.

(9) Infrared transmittance

A molded sheet was cut into a 35 mm × 50 mm test piece to conduct measurement by a transmission method with use of an FT-IR Fourier transform infrared spectrophotometer ("FT/IR4100" manufactured by JASCO Corp.). As measurement conditions, a resolution was 4 cm$^{-1}$, an integration count was 32, and a wavelength region was from 8 to 14 μm. An average infrared transmittance was obtained by measuring an infrared transmittance for every 1 cm$^{-1}$ area in the wavelength range of 1250 to 714 cm$^{-1}$, adding all the resultant values, and dividing the added value by the total number of data pieces.

(10) Falling weight impact strength

A sheet-shaped test piece of 100 mm long and 100 mm wide was formed by using an IFW testing machine manufactured by ROSAND. At room temperature, a striker with a striker diameter of 10 mmϕ and a striker weight of 3.2 kgf was fallen on the test piece at a falling speed of 5.9 m/s to impart an impact. An impact energy in this case was used as the falling weight impact strength.

(11) Stretching orientation parameter (f)

For WAXS measurement, a molded sheet was cut into a 35 mm × 50 mm test piece, and "Nano Viewer" manufactured by Rigaku Corp. was used to conduct measurement under the following conditions.
As an optical system, a point collimation (1st: 0.4 mmφ, 2nd: 0.2 mm, guard: 0.6 mmφ) was used to emit an X-ray from a sheet normal line direction (Through View). As a detector, an imaging plate was used, and with a camera length of 78.8 mm and measurement time of 15 minutes, an X-ray was emitted to acquire a WAXS profile scattering image. Based on the acquired WAXS profile scattering image, Azimuthal dependency of a peak (2θ = 21.2°) intensity derived from a (110) plane was calculated. A range of 21.0° < 2θ < 22.0° was integrated, and a half width (Δ) of the peak obtained from a relationship diagram between an azimuth and normalized scattering intensity was determined as shown in Formula (4) below:

$$f = 1 - (\Delta/360°) \qquad\qquad (4)$$

(12) Field inspection by visual observation and infrared thermography

A protective cover was placed at a distance of 15 mm from an electric connection terminal inside a distribution board, and a visual observation test (visibility confirmation by visual observation) and an infrared thermography test (detection confirmation of a temperature difference by infrared thermography) were conducted. The infrared thermography test was conducted by using an infrared thermography apparatus "TH710ZWV" manufactured by NEC San-ei Instruments, Ltd.

(12-1) Visibility confirmation by visual observation

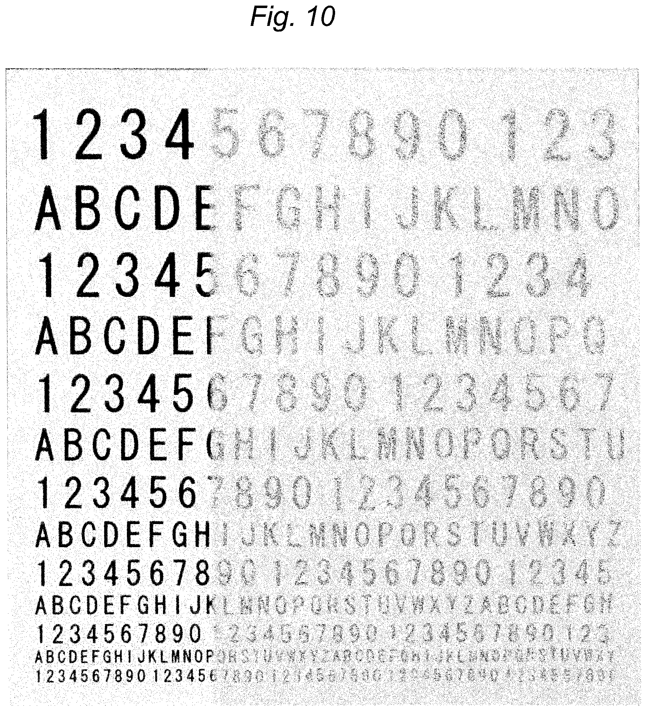

A protective cover (protective cover consisting of a light transmission section) 7 was placed at a position separated by 200 mm from a character table 6 with characters in different font sizes written thereon, and a digital camera 81 was placed at a position distant by about 600 mm from the character table 6 through the protective cover 7 so as to take an image of the character table 6. There were seven character height sizes for the characters printed on the character table 6, including the character heights of 2, 3, 4, 5, 6, 7 and 8 mm (see a left-side region of Figure 10). The type of the characters includes numerals (0 to 9) and alphabets (A-Z), and MS Gothic was selected as a font type. As the digital camera 81, a digital camera (model: Fine Pix S2500HD, 12,200,000 effective pixels) manufactured by Fuji Photo Film Co., Ltd. was used for photographing. In the case where the character with a character height of 2 mm could not visually be confirmed at the distance of 200 mm, a distance between the character table 6 and the protective cover 7 was set to 10 mm, and the same operation was repeated.

(Evaluation of visibility by visual observation)

A (excellent): Visual confirmation of the character with a character height of 2 mm was easily succeeded at the distance of 200 mm.
B (good): Visual confirmation of the character with a character height of 2 mm was barely succeeded at the distance of 200 mm.
C (passable): Although the character with a character height of 2 mm could not visually be confirmed at the distance of 200 mm, the character with a character height of 2 mm could visually be confirmed at the distance of 10 mm.
D (bad): The character with a character height of 2 mm could not visually be confirmed at the distance of 10 mm.

(12-2) Detection confirmation of temperature difference by infrared thermography

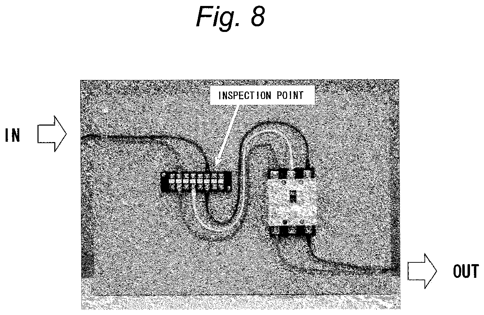

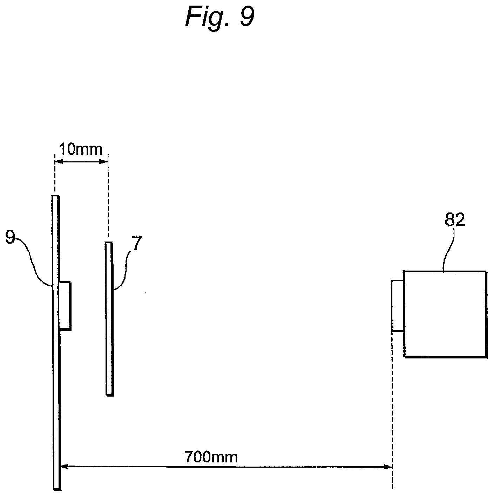

Figure 8 is a photograph taken for showing placement of an apparatus for the field inspection performed in the Examples. As shown in Figure 8, a circuit connecting a terminal block 9 and a no fuse breaker (NFB: rated current of 30 A) was connected to a 100-V alternate power source and to a 1200-W halogen heater for heating that serves as a load of the NFB by a 2-mm$^2$ plastic electric wire (maximum allowed current of 27A) to examine detectability of a temperature difference by infrared thermography. A passing current is 12 A (12 A is obtained since 100 V is connected to 1200 W). Only one side was of the terminal block 9 intentionally set to the state of abnormal heating by connecting a primary-side electric wire to a connection terminal on the one side with a conductive plastic sheet interposed therebetween, so that connection resistance thereof was increased. An infrared thermography apparatus 82, the protective cover 7, and the terminal block 9 were placed as shown in Figure 9, and detectability of temperature difference in the state of abnormal heating was determined using a thermal image. A distance between the terminal block 9 and the infrared thermography apparatus 82 was set to 700 mm, and a distance between the terminal block 9 and the protective cover 7 was set to 10 mm (see Figure 9). As the infrared thermography apparatus 82, a thermo tracer (model: TH7102WV, temperature range of -40 to 120°C) made by NEC San-ei Instruments, Ltd. was used. When a photograph was taken, the infrared transmittance of the protective cover 7 used for measurement was corrected (transmittance correction), and then a thermal image was obtained.

(Evaluation of visibility in temperature difference detection by infrared thermography)

A (excellent): Even without transmittance correction, temperature increase was detected and a temperature difference could be confirmed.
B (good): With transmittance correction, temperature increase was detected and a temperature difference could be confirmed.
C (passable): With transmittance correction, temperature increase was barely detected and a temperature difference could barely be confirmed.
D (bad): Even with transmittance correction, temperature increase was not detected and a temperature difference could not be confirmed.

(Example 1)

A skived sheet was formed with use of an ultrahigh molecular weight polyethylene (UHMWPE, trade name "Sunfine (trademark) UL901" with a density of 920 kg/m$^3$, an intrinsic viscosity (I.V) of 16.9 dL/g, and a melting point of 128°C) manufactured by Asahi Kasei Chemicals Corp. The skived sheet was skived to a thickness of 1.0 mm. A rolled sheet was formed with a roll gap width (roll gap) of 0.25 mm, a roll temperature of 120°C and a roll rotation speed of 1.0 m/minute, and adjusted to have a final thickness of 0.3 mm. That is, a ratio of the thickness before rolling to the thickness after rolling was 3.3. Values of the respective physical properties are shown in Table 1.

(Example 2)

A sheet was formed under the same conditions as those of Example 1 except that the thickness of the skived sheet was set to 2.5 mm, the roll gap was set to 0.35 mm, and the thickness of the final sheet was set to 0.5 mm. Values of the respective physical properties are shown in Table 1.

(Example 3)

A rolled sheet was formed under the same conditions as those of Example 1 except that the thickness of the skived sheet was set to 3.0 mm, the roll gap was set to 0.50 mm, and the thickness of the final sheet was set to 0.8 mm. Values of the respective physical properties are shown in Table 1.

(Example 4)

A rolled sheet was formed under the same conditions as those of Example 1 except that the thickness of the skived sheet was set to 3.7 mm, the roll gap was set to 0.55 mm, and the thickness of the final sheet was set to 1.0 mm. Values of the respective physical properties are shown in Table 1.

(Example 5)

A rolled sheet was formed under the same conditions as those of Example 1 except that the thickness of the skived sheet was set to 3.5 mm, the roll gap was set to 0.82 mm, and the thickness of the final sheet was set to 1.2 mm. Values of the respective physical properties are shown in Table 1.

(Example 6)

A skived sheet was formed with use of an ultrahigh molecular weight polyethylene (UHMWPE, trade name "Sunfine (trademark) UL901" with a density of 920 kg/m$^3$, an intrinsic viscosity (I.V) of 16.9 dL/g, and a melting point of 128°C) manufactured by Asahi Kasei Chemicals Corp. The thickness of the skived sheet was 0.5 mm. Values of the respective physical properties are shown in Table 1.

(Example 7)

A skived sheet was formed with use of an ultrahigh molecular weight polyethylene (UHMWPE, trade name "Sunfine (trademark) UL901") manufactured by Asahi Kasei Chemicals Corp. The thickness of the skived sheet was 1.0 mm. Values of the respective physical properties are shown in Table 1.

(Comparative Example 1)

A press sheet was formed with a 1.0-mm thick metal mold by using an ultrahigh molecular weight polyethylene (UHMWPE, trade name "Sunfine (trademark) UL901") manufactured by Asahi Kasei Chemicals Corp. as a raw material. The thickness of the skived sheet was 1.0 mm. Values of the respective physical properties are shown in Table 1.

(Comparative Example 2)

A press sheet was formed under the same conditions as those of Comparative Example 1 except that an ultrahigh molecular weight polyethylene (UHMWPE, "Sunfine (trademark) UH950" with a density of 935 kg/m$^3$, an intrinsic viscosity (I.V) of 19.6 dL/g, and a melting point of 145°C) manufactured by Asahi Kasei Chemicals Corp. was used as a raw material. The thickness of the skived sheet was 1.0 mm. Values of the respective physical properties are shown in Table 1.

[Table 1]

| | Example 1 | Example 2 | Example 3 | Example 4 | Example 5 | Example 6 | Example 7 | Comparative Example 1 | Comparative Example 2 |
|---|---|---|---|---|---|---|---|---|---|
| Total light transmittance (%) | 89.0 | 87.0 | 87.9 | 85.5 | 83.4 | 86.8 | 80.2 | 68.6 | 65.5 |
| Average infrared transmittance (%) (8-14 μm) | 61.8 | 48.4 | 39.7 | 31.4 | 25.8 | 49.7 | 30.2 | 31.3 | 30.5 |
| Haze (%) | 6.2 | 4.3 | 9.6 | 11.1 | 18.5 | 65.5 | 73.5 | 45.0 | 75.0 |
| Thickness (mm) | 0.3 | 0.5 | 0.8 | 1.0 | 1.2 | 0.5 | 1.0 | 1.0 | 1.0 |
| Falling weight impact strength (J) | 11.7 | 14.1 | 15.6 | 14.1 | 17.7 | 3.8 | 7.9 | 7.9 | 9 |
| Raw material | UHMWPE | UHMWPE | UHMWPE | UHMWPE | UHMWPE | UHMWPE | UHMWPE | UHMWPE | UHMWPE |
| Visibility by visual observation | A | A | A | A | B | B | B | C | C |
| Visibility in temperature difference detection by infrared thermography | A | A | A | A | A | A | A | A | A |
| I.V (dL/g) | 16.9 | 16.9 | 16.9 | 16.9 | 16.9 | 16.9 | 16.9 | 16.9 | 19.6 |
| Density (kg/m$^3$) | 920 | 920 | 920 | 920 | 920 | 920 | 920 | 920 | 935 |
| Stretching ratio x (times) | 3.3 | 4.8 | 3.9 | 3.7 | 2.9 | 1.0 | 1.0 | 1.0 | 1.0 |

(Example 8)

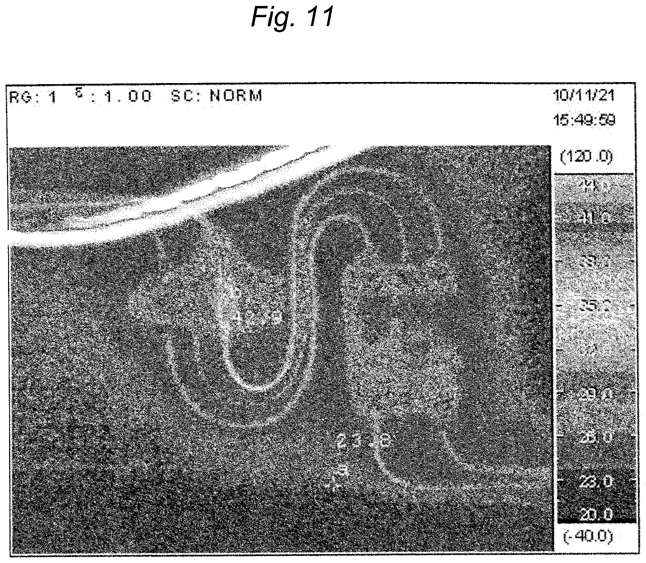

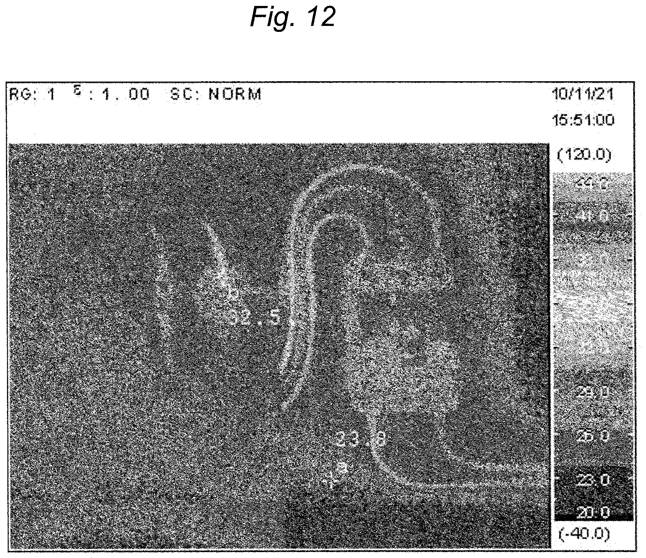

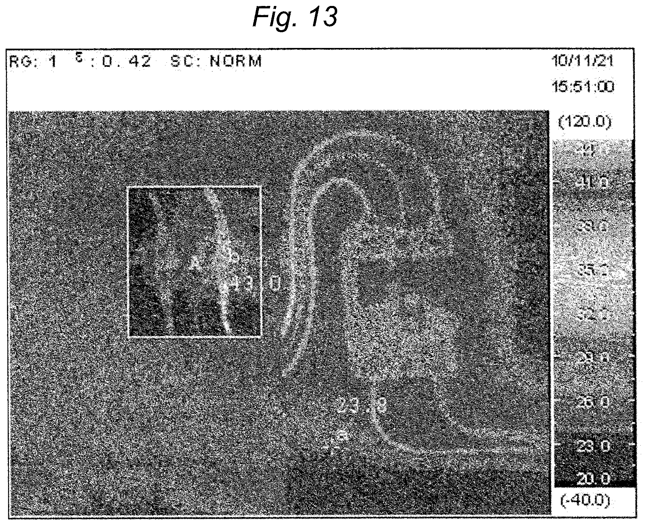

A high-density polyethylene obtained with use of a metallocene catalyst (HDPE, trade name "CREOLEX (trademark) K4125" with a density of 941 kg/m$^3$, MFR of 2.5 g/10 minutes, and a melting point of 126°C) manufactured by Asahi Kasei Chemicals Corp. was used as a raw material. With a single screw extruder (manufactured by Toshiba Corp., screw diameter of $\phi$65 mm, L/D = 28), under the extrusion conditions of a cylinder temperature, a die temperature and an adapter die temperature being 190°C each and a screw speed being 50 rpm, a molten parison was extruded by using a T-die with a die width of 400 mm and a lip with of 5.5 mm. The molten parison was then introduced into a chilled roll, which was adjusted to the temperature of 95°C and had a gap of 5 mm, to form a 5.0-mm thick extruded sheet. The obtained extruded sheet was made to pass through a 100°C heating tank and was held so that the surface temperature of the extruded sheet after passing the heating tank was 80°C ± 15°C. The surface temperature of the extruded sheet measured using an infrared sensor immediately before passing the rolls was 84°C. This pre-heated extruded sheet was made to pass through a rolling machine under the conditions of a roll gap being 0.85 mm, a roll temperature being 120°C, a roll rotation speed being 1.0 m/minute, and a take-up tension being 400 N ± 20 N, by which a 1.0-mm thick rolled sheet was formed. Values of the respective physical properties are shown in Table 2.
In the field inspection performed by visual observation in Example 8, abnormalities were not confirmed. Herein, a photograph of the character table in Example 8 is shown as one example. Figure 10 shows the character table used for visibility check by visual observation in the present Example. The photograph shows the state where a right-side region of the character table is covered with the protective cover of Example 8.
In the field inspection performed by infrared thermography in Example 8, abnormalities were not confirmed either. Here, a thermal image photograph of the field inspection by the infrared thermography in Example 8 was shown as one example. Figure 11 shows a thermal image photograph showing the field inspection (without the protective cover) by the infrared thermography in Example 8. The temperature of a measuring target in Figure 11 was 42.9°C. Figure 12 shows a thermal image photograph in the field inspection (with the protective cover) by the infrared thermography in Example 8. The temperature of a measuring target in Figure 12 was 32.5°C. Figure 13 is a thermal image photograph showing the field inspection (with the protective cover and with transmittance correction) by the infrared thermography in Example 8. The temperature of a measuring target in Figure 13 was 43.0°C.
As is clear from the foregoing, the results of respective field inspections by visual observation and by infrared thermography were satisfactory.

(Example 9)

A high-density polyethylene obtained with use of a metallocene catalyst (HDPE, trade name "CREOLEX (trademark) K4125" with a density of 941 kg/m$^3$, MFR of 2.5 g/10 minutes, and a melting point of 126°C) manufactured by Asahi Kasei Chemicals Corp. was used, and with a single screw extruder (manufactured by Soukensya, screw diameter of $\phi$30 mm, L/D = 38), under the extrusion conditions of a cylinder temperature, a die temperature and an adapter die temperature being 190°C each and a screw speed being 100 rpm, a molten parison was extruded by using a T-die with a die width of 300 mm, and a lip with of 1.5 mm. The molten parison was then introduced into a chilled roll, which was adjusted to the temperature of 95°C and had a gap of 2 mm, to form a 2.0-mm thick extruded sheet. The obtained extruded sheet at room temperature was made to pass through a rolling machine under the conditions of a roll gap being 0.75 mm, a roll temperature being 120°C, a roll rotation speed being 1.0 m/minute, and a take-up tension being 400 N ± 20 N, by which a 0.9-mm thick rolled sheet was formed. Values of the respective physical properties are shown in Table 2.

(Example 10)

The rolled sheet was formed under the same conditions as those of Example 9 except that the roll gap was set to 0.50 mm. The thickness of the rolled sheet was 0.7 mm. Values of the respective physical properties are shown in Table 2.

(Example 11)

A rolled sheet was formed under the same conditions as those of Example 9 except that the roll gap was set to 0.35 mm. The thickness of the rolled sheet was 0.5 mm. Values of the respective physical properties are shown in Table 2.

(Example 12)

A rolled sheet was formed under the same conditions as those of Example 9 except that the rolled sheet had a thickness of 2.5 mm and a roll gap of 0.25 mm. The thickness of the rolled sheet was 0.3 mm. Values of the respective physical properties are shown in Table 2.

(Comparative Example 3)

A press sheet was formed under the same conditions as those of Comparative Example 1 except that a high-density polyethylene obtained with use of a metallocene catalyst (HDPE, trade name "CREOLEX (trademark) K4125" with a density of 941 kg/m$^3$, MFR of 2.5 g/10 minutes, and a melting point of 126°C) manufactured by Asahi Kasei Chemicals Corp. was used. The press sheet had a thickness of 1.0 mm. Values of the respective physical properties are shown in Table 2.

[Table 2]

| Example | Example 8 | Example 9 | Example 10 | Example 11 | Example 12 | Comparative Example 3 |
|---|---|---|---|---|---|---|
| Total light transmittance (%) | 88.1 | 79.9 | 84.7 | 89.5 | 88.9 | 63.9 |
| Average infrared transmittance (%) (8-14 $\mu$m) | 32.0 | 35.1 | 39.4 | 51.4 | 62.0 | 31.0 |
| Haze (%) | 9.3 | 59.8 | 27.4 | 4. 6 | 4.0 | 85.0 |
| Thickness (mm) | 1.0 | 0.9 | 0.7 | 0.5 | 0.3 | 1.0 |
| Falling weight impact strength (J) | 3.2 | < 1 | 2.9 | 1.8 | 4.4 | < 1 |
| Raw material | HDPE | HDPE | HDPE | HDPE | HDPE | HDPE |
| Visibility by visual observation | A | B | A | A | A | D |
| Visibility in temperature difference detection by infrared thermography | A | A | A | A | A | A |
| MFR (g/10 minutes) | 2.5 | 2.5 | 2.5 | 2.5 | 2.5 | 2.5 |
| Density (kg/m$^3$) | 941 | 941 | 941 | 941 | 941 | 941 |
| Stretching ratio x (times) | 5.0 | 2.2 | 3.0 | 4.5 | 8.3 | 1.0 |
| Orientation parameter f | 0.946 | 0.850 | - | - | - | - |

(Example 13)

An extruded sheet was formed under the same conditions as those of Example 9 except that a linear low-density polyethylene (LLDPE, trade name "ULTZEX 3520L" with a density of 931 kg/m$^3$, MFR of 2.1 g/10 minutes, and a melting point of 124°C) manufactured by Prime Polymer Co., Ltd. was used as a raw material. Next, a rolled sheet was formed under the same conditions as those of Example 8 except that the roll gap was set to 0.35 mm, the roll temperature was set to 110°C, and the taking-up tension was set to 240 N. The rolled sheet has a thickness of 0.6 mm. Values of the respective physical properties are shown in Table 3.

(Example 14)

An extruded sheet was formed under the same conditions as those of Example 13. A rolled sheet was formed under the same conditions as those of Example 9 except that the tension at the time of taking up the sheet after rolling was set to 390 N. The thickness of the rolled sheet was 0.5 mm. Values of the respective physical properties are shown in Table 3.

(Example 15)

A press sheet was formed with a 0.5-mm thick metal mold by using a very low-density polyethylene (VLDPE, trade name "Nipolon 08L55A" with a density of 884 kg/m$^3$, MFR of 3.6 g/10 minutes) manufactured by Tosoh Corp. as a raw material. Values of the respective physical properties are shown in Table 3.

(Example 16)

A press sheet was formed under the same conditions as those of Example 15 by using a very low-density polyethylene (VLDPE, trade name "Excellen VL-100" with a density of 900 kg/m$^3$, MFR of 0.8 g/10 minutes) manufactured by Sumitomo Chemical Co., Ltd. as a raw material. Values of the respective physical properties are shown in Table 3.

(Example 17)

A press sheet was formed under the same conditions as those of Example 15 except that a very low-density polyethylene (VLDPE, trade name "Nipolon 08L55A" with a density of 884 kg/m$^3$, MFR of 3.6 g/10 minutes) manufactured by Tosoh Corp. was used as a raw material and a 1.0-mm thick metal mold was used. Values of the respective physical properties are shown in Table 3.

(Example 18)

A press sheet was formed under the same conditions as those of Example 15 except that a very low-density polyethylene (VLDPE, trade name "Excellen VL-100" with a density of 900 kg/m$^3$, MFR of 0.8 g/10 minutes) manufactured by Sumitomo Chemical Co., Ltd. was used as a raw material and a 1.0-mm thick metal mold was used. Values of the respective physical properties are shown in Table 3.

(Example 19)

A press sheet was formed under the same conditions as those of Example 15 by using a linear low-density polyethylene (LLDPE, trade name "MORETEC 0278G" with a density of 939 kg/m$^3$, and MFR of 2.8 g/10 minutes) manufactured by Prime Polymer Co., Ltd. as a raw material. Values of the respective physical properties are shown in Table 3.

(Example 20)

A press sheet was formed under the same conditions as those of Example 15 by using a linear low-density polyethylene (LLDPE, trade name "Evolue SP2520" with a density of 925 kg/m$^3$, and MFR of 1.9 g/10 minutes) manufactured by Prime Polymer Co., Ltd. as a raw material. Values of the respective physical properties are shown in Table 3.

(Example 21)

A press sheet was formed under the same conditions as those of Example 15 by using a linear low-density polyethylene (LLDPE, trade name "ULTZEX 3520L" with a density of 931 kg/m$^3$, MFR of 2.1 g/10 minutes, and a melting point of 124°C) manufactured by Prime Polymer Co., Ltd. as a raw material. Values of the respective physical properties are shown in Table 3.

(Example 22)

A press sheet was formed under the same conditions as those of Example 15 by using a low-density polyethylene (LDPE, trade name "Suntec LD M2713" with a density of 929 kg/m$^3$, and MFR of 1.3 g/10 minutes) manufactured by Asahi Kasei Chemicals Corp. as a raw material. Values of the respective physical properties are shown in Table 3.

(Example 23)

A press sheet was formed the same conditions as those of Example 15 by using an ethylene vinyl acetate copolymer (EVA, trade name "Suntec EVA EF0510" with a vinyl acetate concentration of 4.8% and MFR of 1.0 g/10 minutes) manufactured by Asahi Kasei Chemicals Corp. as a raw material. Values of the respective physical properties are shown in Table 3.

(Example 24)

A press sheet was formed under the same conditions as those of Example 15 by using an ethylene vinyl acetate copolymer (EVA, trade name "Suntec EVA EF0910" with a vinyl acetate concentration of 9.0% and MFR of 1.0 g/10 minutes) manufactured by Asahi Kasei Chemicals Corp. as a raw material. Values of the respective physical properties are shown in Table 3.

(Example 25)

A press sheet was formed under the same conditions as those of Example 15 by using an ethylene vinyl acetate copolymer (EVA, trade name "Suntec EVA EF1531" with a vinyl acetate concentration of 15.0% and MFR of 3.0 g/10 minutes) manufactured by Asahi Kasei Chemicals Corp. as a raw material. Values of the respective physical properties are shown in Table 3.

(Example 26)

A press sheet was formed under the same conditions as those of Example 15 by using a polypropylene (PP, trade name "Novatec EA9ET" with a density of 900 kg/m$^3$, MFR of 0.5 g/10 minutes) manufactured by Prime Polymer Co., Ltd. Values of the respective physical properties are shown in Table 3.

[Table 3]

| Example | Example 13 | Example 14 | Example 15 | Example 16 | Example 17 | Example 18 | Example 19 | Example 20 | Example 21 | Example 22 | Example 23 | Example 24 | Example 25 | Example 26 |
|---|---|---|---|---|---|---|---|---|---|---|---|---|---|
| Total light transmittance (%) | 89.4 | 88.5 | 91.1 | 89.5 | 91.3 | 86.3 | 86.4 | 89.9 | 87.8 | 89.1 | 89.2 | 90.7 | 91.2 | 89.6 |
| Average infrared transmittance (%) (8-14 μm) | 38.3 | 39.8 | 21.9 | 36.0 | 8.0 | 12.0 | 48.8 | 45.2 | 41.9 | 48.0 | 15.5 | 9.2 | 6.3 | 24.0 |
| Haze (%) | 6.1 | 5.3 | 6.1 | 6.6 | 7.3 | 12.6 | 52.4 | 78.9 | 54.5 | 78.3 | 22.7 | 15.4 | 11.1 | 26.2 |
| Thickness (mm) | 0.6 | 0.5 | 0.5 | 0.5 | 1.0 | 1.0 | 0.5 | 0.5 | 0.5 | 0.5 | 0.5 | 0.5 | 0.5 | 0.5 |
| Falling weight impact strength (J) | 3.3 | 4.2 | < 1 | < 1 | < 1 | < 1 | < 1 | < 1 | < 1 | < 1 | < 1 | < 1 | < 1 | < 1 |
| Raw material | LLDPE | LLDPE | VLDPE | VLDPE | VLDPE | VLDPE | LLDPE | LLDPE | LLDPE | LDPE | EVA | EVA | EVA | PP |
| Visibility by visual observation | A | A | A | A | A | A | C | C | C | C | B | B | A | B |
| Visibility in temperature difference detection by infrared thermography | A | A | A | A | C | C | A | A | A | A | C | C | C | A |
| MFR (g/10 minutes) | 2.1 | 2.1 | 3.6 | 0.8 | 3.6 | 0.8 | 2.8 | 1.9 | 2.1 | 1.3 | 1.0 | 1.0 | 3.0 | 0.5 |
| Density (kg/m ) | 931 | 931 | 884 | 900 | 884 | 900 | 939 | 925 | 931 | 929 | - | - | - | 900 |
| Stretching ratio x (times) | 3.6 | 3.9 | 1.0 | 1.0 | 1.0 | 1.0 | 1.0 | 1.0 | 1.0 | 1.0 | 1.0 | 1.0 | 1.0 | 1.0 |

EP 2 654 148 B1

(Comparative Example 4)

Various physical properties of a 0.5-mm thick polycarbonate sheet (PC, trade name "PCSM PS600") manufactured by Takiron Co., Ltd. were measured. Values of the respective physical properties are shown in Table 4.

(Comparative Example 5)

Various physical properties of a 1.0-mm thick sheet made of polyethylene terephthalate (PET, trade name "PETEC-6010") manufactured by Takiron Co., Ltd. were measured. Values of the respective physical properties are shown in Table 4.

(Comparative Example 6)

Various physical properties of a 0.6-mm thick sheet made of polymethyl methacrylate (PMMA, manufactured by Asahi Kasei Chemicals Corp., trade name "DELAGLAS A" with a density of 1190 $kg/m^3$, a refractive index of 1.49, and a Charpy impact strength of 19 $kJ/m^2$, and a bending strength of 120 MPa) were measured. The Charpy impact strength was measured according to ISO 179/1fU and the bending strength was measured according to ISO 178. Values of the respective physical properties are shown in Table 4.

(Comparative Example 7)

Various physical properties of a 0.8-mm thick sheet made of polymethyl methacrylate (PMMA, manufactured by Asahi Kasei Chemicals Corp., trade name "DELAGLAS SR" with a density of 1180 $kg/m^3$, a refractive index of 1.49, and a Charpy impact strength of 47 $kJ/m^2$, and a bending strength of 94 MPa) were measured. Values of the respective physical properties are shown in Table 4.

(Comparative Example 8)

A press sheet was formed under the same conditions as those of Example 16 except that a high-density polyethylene (HDPE, trade name "KM590L" with a density of 962 $kg/m^3$, MFR of 5.0 g/10 minutes) manufactured by JPO Corp. was used as a raw material. The press sheet had a thickness of 1.1 mm. Values of the respective physical properties are shown in Table 4.

[Table 4]

| Example | Comparative Example 4 | Comparative Example 5 | Comparative Example 6 | Comparative Example 7 | Comparative Example 8 |
|---|---|---|---|---|---|
| Total light transmittance (%) | 89.2 | 90.1 | 92.5 | 92.2 | 63.3 |
| Average infrared transmittance (%) (8-14 μm) | 0.3 | 0.0 | 0.4 | 0.2 | 25.0 |
| Haze (%) | 0.3 | 0.4 | 1.1 | 1.5 | 95.0 |
| Thickness (mm) | 0.5 | 1.0 | 0.6 | 0.8 | 1.1 |
| Falling weight impact strength (J) | 15.9 | 7.3 | < 1 | < 1 | < 1 |
| Raw material | PC | PET | PMMA | PMMA | HDPE |
| Visibility by visual observation | A | A | A | A | D |
| Visibility in temperature difference detection by infrared thermography | D | D | D | D | A |
| MFR (g/10 minutes) | - | - | - | - | 5.0 |
| Density ($kg/m^3$) | - | - | 1190 | 1180 | 962 |

(continued)

| Example | Comparative Example 4 | Comparative Example 5 | Comparative Example 6 | Comparative Example 7 | Comparative Example 8 |
|---|---|---|---|---|---|
| Stretching ratio x (times) | 1.0 | 1.0 | 1.0 | 1.0 | 1.0 |

As described in the foregoing, it was confirmed that Examples had sufficient transparency both to visible rays and infrared rays on the practical basis. On the contrary, the results of the field inspections by visual observation or infrared thermography were dissatisfactory in Comparative Examples, and it was confirmed that their transparency to at least either visible rays or infrared rays was poor.

This application is based on Japanese patent application (Japanese Patent Application No. 2010-277410) filed with the Japan Patent Office on December 13, 2010, and the contents of which are incorporated herein by reference in their entirety.

Industrial Applicability

The infrared transmissive protective cover of the present invention can be used as protective covers and the like for such components as connection terminals inside a distribution board.

Reference Signs List

1, 2, 4, 7 ... Infrared transmissive protective cover (protective cover), 3, 5, 9 ... Terminal block, 6 ... Character table, 10 ... Light transmission section, 12 ... Frame body, 14 ... Pressing plate, 16 ... Small screw, 31, 32 ... Insertion groove, 51, 52 ... Screw, 81 ... Digital camera, 82 ... Infrared thermography apparatus, H ... Opening

**Claims**

1.  An infrared transmissive protective cover, comprising a light transmission section, wherein
    the light transmission section is made of a resin sheet containing a resin composition,
    a total light transmittance of the light transmission section in a visible light region is 70% or more, and an average infrared transmittance of the light transmission section in a wavelength range of 8 to 14 $\mu$m is 5% or more,
    a thickness of the light transmission section is from 0.2 to 3 mm, and
    a falling weight impact strength of the light transmission section is 1 J or more.

2.  The infrared transmissive protective cover according to claim 1, wherein
    the average infrared transmittance of the light transmission section in the wavelength range of 8 to 14 $\mu$m is 20% or more.

3.  The infrared transmissive protective cover according to claim 1 or 2, wherein
    a haze value of the light transmission section is 40% or less.

4.  The infrared transmissive protective cover according to any one of claims 1 to 3, wherein
    the resin composition comprises a thermoplastic resin.

5.  The infrared transmissive protective cover according to claim 4, wherein
    the thermoplastic resin is a polyolefin resin.

6.  The infrared transmissive protective cover according to claim 5, wherein
    a density of the polyolefin resin is from 925 to 945 kg/m$^3$.

7.  The infrared transmissive protective cover according to claim 5, wherein
    an intrinsic viscosity of the polyolefin resin is 7 dL/g or more.

8.  The infrared transmissive protective cover according to any one of claims 1 to 7, comprising:

the light transmission section; and
a frame body that supports the light transmission section.

9. A method for manufacturing the infrared transmissive protective cover according to any one of claims 1 to 8, the method comprising
a molding step of obtaining the resin sheet from the resin composition by any method selected from the group consisting of an extrusion method, an injection molding method, a press molding method, and a skiving method.

10. The method for manufacturing the infrared transmissive protective cover according to claim 9, the method further comprising
a step of stretching, rolling or extending the resin sheet at a temperature less than a melting point of the resin composition after the molding step.

11. A method for monitoring a heating element protected with the infrared transmissive protective cover according to any one of claims 1 to 8 by visual observation and by using infrared thermography.


**Patentansprüche**

1. Infrarotdurchlässige Schutzabdeckung, umfassend einen Lichttransmissionsbereich, wobei

der Lichttransmissionsbereich aus einer Harzschicht besteht, die eine Harzmischung enthält,
eine Gesamtlichtdurchlässigkeit des Lichttransmissionsbereichs in einem sichtbaren Lichtbereich 70 % oder höher ist, und eine durchschnittliche Infrarotdurchlässigkeit des Lichttransmissionsbereichs in einem Wellenlängenbereich von 8 bis 14 $\mu$m 5 % oder höher ist,
eine Dicke des Lichttransmissionsbereichs zwischen 0,2 und 3 mm liegt, und
eine Fallgewicht-Schlagzähigkeit des Lichttransmissionsbereichs 1 J oder höher ist.

2. Infrarotdurchlässige Schutzabdeckung nach Anspruch 1, wobei
die durchschnittliche Infrarotdurchlässigkeit des Lichttransmissionsbereichs in dem Wellenlängenbereich von 8 bis 14 $\mu$m 20 % oder höher ist.

3. Infrarotdurchlässige Schutzabdeckung nach Anspruch 1 oder 2, wobei
ein Trübungswert des Lichttransmissionsbereichs 40 % oder weniger ist.

4. Infrarotdurchlässige Schutzabdeckung nach einem der Ansprüche 1 bis 3, wobei
die Harzmischung ein thermoplastisches Harz umfasst.

5. Infrarotdurchlässige Schutzabdeckung nach Anspruch 4, wobei
das thermoplastische Harz ein Polyolefinharz ist.

6. Infrarotdurchlässige Schutzabdeckung nach Anspruch 5, wobei
eine Dichte des Polyolefinharzes zwischen 925 und 945 kg/m$^3$ liegt.

7. Infrarotdurchlässige Schutzabdeckung nach Anspruch 5, wobei
eine Grenzviskosität des Polyolefinharzes 7 dL/g oder höher ist.

8. Infrarotdurchlässige Schutzabdeckung nach einem der Ansprüche 1 bis 7, umfassend

den Lichttransmissionsbereich; und
einen Rahmenkörper, der den Lichttransmissionsbereich trägt.

9. Verfahren zum Herstellen der infrarotdurchlässigen Schutzabdeckung nach einem der Ansprüche 1 bis 8, wobei das Verfahren umfasst
einen Formschritt eines Erhaltens der Harzschicht aus der Harzmischung durch ein beliebiges Verfahren, das aus der Gruppe ausgewählt, die besteht aus einem Extrusionsverfahren, einem Spritzgießverfahren, einem Formpressverfahren und einem Wälzschälverfahren.

**EP 2 654 148 B1**

**10.** Verfahren zum Herstellen der infrarotdurchlässigen Schutzabdeckung nach Anspruch 9, wobei das Verfahren ferner umfasst

einen Schritt von Strecken, Walzen oder Dehnen der Harzschicht bei einer Temperatur kleiner als ein Schmelzpunkt der Harzmischung nach dem Formschritt.

**11.** Verfahren zum Überwachen eines mit der infrarotdurchlässigen Schutzabdeckung nach einem der Ansprüche 1 bis 8 geschützten Heizelements durch Sichtprüfung und durch Verwendung von Infrarot-Thermografie.

**Revendications**

**1.** Couvercle protecteur transmettant les infrarouges, comprenant une section de transmission de la lumière, dans lequel

la section de transmission de la lumière est constituée d'une feuille de résine contenant une composition de résine, une transmittance lumineuse totale de la section de transmission de la lumière dans une région de lumière visible est de 70 % ou plus, et une transmittance infrarouge moyenne de la section de transmission de la lumière dans une gamme de longueurs d'onde de 8 à 14 $\mu$m est de 5 % ou plus,

une épaisseur de la section de transmission de la lumière est de 0,2 à 3 mm, et

une résistance à la chute d'un poids de la section de transmission de la lumière est de 1 J ou plus.

**2.** Couvercle protecteur transmettant les infrarouges selon la revendication 1, dans lequel

la transmittance infrarouge moyenne de la section de transmission de la lumière dans la gamme de longueurs d'onde de 8 à 14 $\mu$m est de 20 % ou plus.

**3.** Couvercle protecteur transmettant les infrarouges selon la revendication 1 ou 2, dans lequel

une valeur de trouble de la section de transmission de la lumière est de 40 % ou moins.

**4.** Couvercle protecteur transmettant les infrarouges selon l'une quelconque des revendications 1 à 3, dans lequel

la composition de résine comprend une résine thermoplastique.

**5.** Couvercle protecteur transmettant les infrarouges selon la revendication 4, dans lequel

la résine thermoplastique est une résine polyoléfinique.

**6.** Couvercle protecteur transmettant les infrarouges selon la revendication 5, dans lequel

une masse volumique de la résine polyoléfinique est de 925 à 945 kg/m$^3$.

**7.** Couvercle protecteur transmettant les infrarouges selon la revendication 5, dans lequel

une viscosité intrinsèque de la résine polyoléfinique est de 7 dl/g ou plus.

**8.** Couvercle protecteur transmettant les infrarouges selon l'une quelconque des revendications 1 à 7, comprenant :

la section de transmission de la lumière ; et

un corps de cadre qui supporte la section de transmission de la lumière.

**9.** Procédé de fabrication du couvercle protecteur transmettant les infrarouges selon l'une quelconque des revendications 1 à 8, le procédé comprenant :

une étape de moulage consistant à obtenir la feuille de résine à partir de la composition de résine par tout procédé choisi dans le groupe constitué par un procédé d'extrusion, un procédé de moulage par injection, un procédé de moulage à la presse, et un procédé de taillage.

**10.** Procédé de fabrication du couvercle protecteur transmettant les infrarouges selon la revendication 9, le procédé comprenant en outre

une étape d'étirage, de laminage ou d'allongement de la feuille de résine à une température inférieure à un point de fusion de la composition de résine après l'étape de moulage.

**11.** Procédé de surveillance d'un élément chauffant protégé par le couvercle protecteur transmettant les infrarouges selon l'une quelconque des revendications 1 à 8 par observation visuelle et par utilisation de la thermographie infrarouge.

25

# Fig. 1

Fig. 2

*Fig. 3*

*Fig. 4*

*Fig. 5*

*Fig. 6*

*Fig. 7*

6      7                                    81

200mm

600mm

## Fig. 8

*Fig. 9*

## Fig. 10

Fig. 11

Fig. 12

## Fig. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3006427 A
- JP 11084233 A
- JP 7143621 A
- JP 2008029119 A
- JP 5043268 A
- JP 2001200108 A
- JP 2010277410 A